# EUROPEAN PATENT APPLICATION

(11) **EP 4 516 426 A1**
(43) Date of publication of application: **05.03.2025**
(21) Application number: 23194039.6
(22) Date of filing: 29.08.2023
(51) Int. Cl.: B22F 1/12, B22F 1/18, B22F 1/102, C22C 1/04, B22F 1/10, B22F 1/054, B22F 7/06, C22C 1/059

(54) **A DIE ATTACH SINTER MATERIAL AND METHOD**

(71) Applicant: Nederlandse Organisatie voor toegepast-natuurwetenschappelijk Onderzoek TNO, 2595 DA 's-Gravenhage (NL); Stichting Chip Integration Technology Center, 6534 AT Nijmegen (NL); Technische Universiteit Delft, 2628 CN Delft (NL)
(72) Inventor: SMITS, Edsger Constant Pieter, 2595 DA's-Gravenhage (NL); VAN ZEIJL, Hendrikus Wilhelmus, 2628 CN Delft (NL); ZHANG, Boyao, 2628 CN Delft (NL)
(74) Representative: V.O.

(57) **Abstract**

In an aspect, a die attach sinter composition (1) is provided. The die attach sinter composition (1) comprising metal (nano) particles (2), and carbonaceous platelets (3). The carbonaceous platelets (3) being dispersed with the metal (nano) particles (2) in a common carrier (4). The carbonaceous platelets (3) being modified with an adhesion promoter (6). Said adhesion promotor (6) being anchored (A) to said platelets (3) and comprises a pendant group (X) having an affinity to binding to a surface of the metal (nano) particles (2). The pendant group (X) of said adhesion promotor (6) capable of remaining stable under reducing conditions during sintering of said metal (nano) particles (2).

## Description

### TECHNICAL FIELD OF THE INVENTION

The present invention is aimed to a die attach sinter composition, to a use of said die attach sinter composition, a method to produce said die attach sinter composition, and to a packaged die product comprising the sintered die attach composition.

### BACKGROUND OF THE INVENTION

Die attach materials are commonly used in the electronics industry to create a conductive bond between a die and leads of a leadframe. Generally, die attach sinter materials are known for having a high electrical and/or thermal conductivity, a high shear and bond strength with the die and the leads of a leadframe and a high temperature resistance able to withstand the high temperatures associated with soldering or reflow processes affiliated with the electronics industry.

A high performance die attach material is essential to provide a mechanical fixation between a die and a substrate such as a die pad or a leadframe. High performance die attach materials are known for efficiently transferring electrical signals and/or heat to the substrates. Typically, die attach materials have a thermal conductivity above 40 W/(m*K) and/or an electrical conductivity above 5 MS/m (IACS). Further, die attach materials are expected to remain solid at temperatures affiliated with the board level reflow temperatures, a corresponding temperature is for example 250°C. Furthermore, high adhesion properties, for example shear strength, are needed at room temperatures as well as at elevated temperatures such as 260°C. Aimed shear strength values for high performance die attach materials are 15MPa or higher as measured at room temperature as well as elevated temperature.

Package level soldering relies on lead(Pb)-rich solder. Nowadays lead-based solders are considered harmful for the environment as well as a health risk. Hence, they are to be avoided. As such, SAC-solders (tin (Sn), silver (Ag), copper (Cu)) have replaced Pb-based solders in board level fixations. SAC-solders are known for withstanding the high temperature (up to 250°C) requirements for soldering. The downside of SAC-solders is that they don't have a sufficiently high melting point (up to 280°C) to be used for board level assembly as well as within the package. Further, also eutectic solders are known in the industry. Eutectic solders have the disadvantage of having lower thermal properties. Therefore, eutectic solders are not ideal for electronics with an increased power and/or heat. As such die attach materials have been continuously investigated. Promising die attach sinter materials are die attach sinter compositions based on a common carrier and pure silver (Ag) and copper (Cu). Pure Ag and Cu based die attach sinter compositions are known for lowering the energy required to fuse Ag and/or Cu (nano) particles and for having conductive properties sought in electronics. The disadvantage of pure Ag and Cu based die attach sinter compositions are their brittle behavior, increasing the risk for crack formation as well as propagation.

As of today, several commercial die attach sinter compositions comprising pure Ag and/or Cu are already available. Known producers of such commercial die attach sinter compositions are Alpha MacDermid, Celanese, Henkel, Hereaus, Kyocera, Mitsui, Namics, Nanojoin, Nihon Handa, Rotaris, Showa Denko, Sumitomo Bakelite, Tanaka, Taiyo, Weldtone.

To achieve high electrically and/or thermally conductive compositions most of the commercial products are a combination of a common carrier such as an epoxy mixed with pure conductive particles like metals. Common used metals are pure copper (Cu) and/or silver (Ag). Pure Ag and Cu are mixed into the common carrier to create a path of least resistance. A drawback of such die attach sinter compositions includes a mismatch in Coefficient of Thermal Expansion (CTE) with the substrates to be bonded such as a die or leads of a leadframe. The high difference in CTE makes the bond prone to cracks. For example, when a packaged die product is (repeatedly) subjected to high temperature fluctuations as for example is noticed in the automotive industry. Cracks can be situated between an interface of the die and the die attach sinter material, between an interface of the leads of a leadframe or leadframe and the die attach sinter material and/or within the die attach sinter material. Cracks have a highly adverse effect on the performance and the lifetime of the packaged die product. For example, cracks can disadvantageously result in hot spot formation damaging the packaged die product. Additionally, die attach sinter materials comprising pure Ag and/or Cu are known for their brittle character. Brittle die attach sinter materials increase the probability of initiating defects during processing, transportation or handling, hence increasing the probability to crack formation.

### SUMMARY

The present invention aims to provide a die attach sinter composition that mitigates and/or eliminates crack formation and/or propagation at the bond interfaces and/or differential interfaces within the die attach sinter compositions such as the carbonaceous platelets and metal particles interfaces.

The present further invention aims to at least retain the same thermal as well as electrical conductivity corresponding to commercial available die attach (sinter) materials.

The composition can further provide compatibility with sintering under acid induced reducing environments, increasing compatibility with bonding to copper or other metals having a native oxide surface layer and inhibiting reaction to cross linking polymers such as epoxies.

Accordingly the invention provides a die attach sinter composition, the die attach sinter composition comprising: metal (nano) particles and filler platelets. The carbonaceous platelets are dispersed with the metal (nano) particles in a common carrier.

To increase adhesion of the carbonaceous additives to the metal constituents within the composition it is proposed to functionalize the carbonaceous with an adhesion promotor.

Accordingly, in a preferred variation the carbonaceous platelets are modified (functionalized) with an adhesion promoter, said adhesion promotor being anchored to said platelets and comprises a pendant group having an affinity to binding to a surface of the metal (nano) particles. Advantageously, the pendant group of said adhesion promotor can be selected to remain stable under reducing conditions during sintering of said metal (nano) particles. Specifically, the adhesion promotor can mitigate or eliminates issues as to protonation of amine functionalized graphene, inhibiting the use of epoxy filler but also during sintering, hindering binding with the metal particles present in the die attach sinter composition under acid induced reducing conditions as known in the field.

Accordingly, the composition can have the advantage of being stable under reducing conditions during sintering, in particular such that the adhesion promoter will remain available to bond with the surface of the metal (nano)particles. Among others, the present disclosure mitigates undesired side reactions, e.g. protonation, of the metal-bonding moieties.

In a further aspect of the present invention, the reducing environment may be achieved through activation of an acid precursor. The acid precursor is provided to remove, possible metal oxides present at an outer surface of the metal (nano) particles.

Furthermore, the metal (nano) particles present in the die attach sinter composition according to the present invention may be selected from one or more of the noble metals, including but not limited to Au, Ag, and Cu. Preferably the metal particles are comprised of Ag, Cu, or a combination thereof. Ag and/or Cu are offer a beneficial combination of comparatively lower energy requirements for sintering while offering excellent having high thermal- as well electrical conductivity when sintered.

In another or further aspect of the present invention, the carbonaceous platelets may be selected from graphene platelets, preferably functionalized graphene platelets. (Functionalized) graphene platelets have the advantage of having an attainable geometry in combination with required material properties such as a high conductivity (thermal and/or electrical), a low Coefficient of Thermal Expansion (CTE), a high stiffness and the ability to preferential orientation during processing, e.g. in line with an interface between the die and the lead frame. Furthermore, the functionalization optionally provides an additional advantage of increasing stability under reducing conditions as well as to increase the affinity (adhesion) of the carbonaceous platelets towards the metal (nano) particles. As detailed below functionalized graphene nanoparticles can, for example, be routinely obtained starting from so-called reduced carbonaceous oxide particles (e.g. reduced graphene oxide platelets (rGO-platelets).

In a further aspect of the present invention, the carbonaceous platelets may comprise an exterior metallized layer covering the (functionalized/modified) carbonaceous platelet. In another further aspect of the present invention the exterior metallized layer may encapsulate the (modified) carbonaceous platelet. When the exterior metallized layer is applied, the metal compound used in the metal (nano) particles and in the exterior metallized layer are preferably, from one and the same metal compound. Providing an exterior metallized layer will stabilize protect the adhesion promoters. Thus even allowing the use of surface binding moieties (such as primary amine and secondary amines), which, when unprotect, would be prone to reaction (e.g. protonating). Further, using the same metal compound for the metal (nano) particles as well as the metallized layer avoids the formation alloys during sintering.

According to the present invention, the pendant group may comprise a functionality selected from one or more of: a thiol, an amine, a carboxylic acid based, a phosphate, or derivative thereof. Preferably, the functionality of the pendant group of the adhesion promoter is a thiol. A thiol pendant group is preferred as thiol-derivative pendant groups provide strong adhesion while reaming stable under reducing environment and not readily undergoing a reaction with epoxy based resin. An exterior metallized layer is strongly preferred, particularly when the pendant group comprises an amine based or a group otherwise less-stable moiety under acid induced sintering under reducing conditions.

In another or yet further aspect of the present invention, the carbonaceous platelets are graphene platelets that preferably have an aspect ratio ≥ 3.10². The aspect ratio being defined as a maximum cross-section dimension over a thickness of said graphene platelets. Preferably, the maximum cross-section is in a range of 5 to 30 µm, more preferably in a range of 18-30 µm, and the thickness is in a range of 1 to 5 nm.

In a further aspect of the present invention, the sintered die attach sinter composition according to the present invention, is preferably configured such that the composition, when sintered, forms a sintered material having a Coefficient of Thermal Expansion (CTE) in a range between 5 and 17 ppm/°C. The CTE can be controlled by routine experimentation. Specifically comprising changing a relative content of carbonaceous fillers with respect to the metal filler, whereby a higher fraction of carbonaceous content decreases the CTE.

A higher aspect ratio as well as a CTE between 5 and 17 ppm/°C, will increase the stress absorption of the bulk die attach sinter material. Hence, mitigating crack formation and/or propagation.

In an even further aspect of the present invention, the die attach sinter composition according to the present invention, comprises a weight content of the carbonaceous platelets in a range of 0.5-4 wt%, preferably in a range of 1-3 wt% (the weight content based on the overall mass of the metal particles comprised in the die attach sinter composition).

Further, the present invention provides a method of packaging a die, said method comprising: disposing a quantity of the die attach sinter composition according to the present invention between bond pads of the die and corresponding leads of a leadframe. Followed by, heating under reducing conditions and at a temperature in a range of 150°C to 300°C, thereby sintering the die attach sinter composition according to the present invention such that a die attach sinter material is formed. Said method may optionally comprise applying a contact pressure between the die and the frame thereby causing spreading of the disposed quantity of die attach sinter composition according to the present invention. Alternatively the sintering may be performed pressure less. The optional contact pressure can advantageously be applied to increase the density of the metal network present in the die attach sinter material in combination with providing preferential alignment of the carbonaceous platelets. Without wishing to be found by theory inventors find that the alignment is at least in part a result of pressure induced flow of the sinter composition between the die and the lead frame.

Furthermore, the present invention provides to a packaged die product, the packaged die product preferably obtained by the method according to the present invention, said product comprising a die, a leadframe, and a sintered die attach material forming an interface between respective bond pads of the die and leads of the leadframe. Preferably, a sintered die attach sinter composition according to the present invention. The sintered die attach sinter material comprises an interlinked network comprised of sintered metal particles and carbonaceous platelets, dispersed with the network of sintered particles. Said carbonaceous platelets being modified with an adhesion promoter anchored to said platelets and that comprises a pendant group bound to a surface of the network comprised of sintered metal particles of metal (nano) particles.

In a further aspect of the present invention, the packaged die products according to the present invention may have a sintered die attach material thickness in the range of 1-150 µm, preferably in the range of 30-50 µm.

In a further aspect of the present invention, the die package product according to the present invention, may have carbonaceous platelets that are preferentially oriented parallel, preferably within ± 20 degrees to the bond pads.

### BRIEF DESCRIPTION OF DRAWINGS

These and other features, aspects, and advantages of the apparatus, systems and methods of the present disclosure will become better understood from the following description, appended claims, and accompanying drawings wherein:
Figure 1 illustrates aspects of a die attach sinter composition 1 according to the present invention. The die attach sinter composition 1 comprising metal (nano) particles 2, carbonaceous platelets 3 and a common carrier 4.
Figure 2 displays a carbonaceous platelet 3 modified with an adhesion promoter 6. The adhesion promoter 6 comprising an anchor A bond to the carbonaceous platelet 3 and a pendant group X.
Figure 3 displays a functionalized graphene platelet 7 as modified carbonaceous platelet 5. The graphene platelet modified with an adhesion promoter 6. The adhesion promoter 6 comprising an anchor and a pendant group X.
Figure 4 displays a modified carbonaceous platelet 5 encapsulated with an exterior metalized layer 8. Said carbonaceous platelet 3 comprising a thickness t₂ and a maximum cross-section dimension L₂.
Figure 5 describes the process steps to obtain a method of a packaged die product 9. The process steps comprising of steps 101, 102 and optionally 103.
Figure 6 displays two packaged die products 14 after 1000 TMCL cycles. In Figure 6A the packaged die contains a reference pressure less silver sinter die attach material. In Figure 6B the packaged die product contains a die attach sinter material according to the present invention, the dotted lines, present in figures 6A and 6B, represent cross section lines.
Figure 7 displays cross sections of the packaged die products 14 obtained in Figure 6. Figure 7A representing cross sections of the packed die comprising the reference die attach sinter material Heraeus D295A. Figure 7B representing the cross section of the of a packed die comprising a die attach sinter material according to the present invention.
Figure 8 displays a Weibull plot for Board-level thermal cycling (TMCL) of the Heraeus D295A reference.
Figure 9 displays a Weibull plot for TMCL of the die attach sinter material according to the present invention.

### DESCRIPTION OF EMBODIMENTS

Terminology used for describing particular embodiments is not intended to be limiting of the invention. As used herein, the singular forms "a", "an" and "the" are intended to include the plural forms as well, unless the context clearly indicates otherwise. The term "and/or" includes any and all combinations of one or more of the associated listed items. It will be understood that the terms "comprises" and/or "comprising" specify the presence of stated features but do not preclude the presence or addition of one or more other features. It will be further understood that when a particular step of a method is referred to as subsequent to another step, it can directly follow said other step or one or more intermediate steps may be carried out before carrying out the particular step, unless specified otherwise. Likewise it will be understood that when a connection between structures or components is described, this connection may be established directly or through intermediate structures or components unless specified otherwise.

As used herein, the term "die attach sinter composition", refers to a composition before a conductive network is formed. Hence, to a composition not cured or sintered. In general, said die attach sinter composition is in liquid or paste form.

As used herein, the term "die attach sinter material", refers a solid material after sintering a die attach sintering composition. Said die attach sintering material comprising a conductive network.

As used herein, the term "wt%", or "weight percentage", or "percentage by weight", refers to the mass fraction of a compound in a mixture divided by the total mass of said mixture, expressed as a percentage between 0 and 100, unless stated otherwise.

As used herein, the term "reducing environment", refers to a surrounding that is capable of removing metal oxides present at an outer surface of a metal (nano) particles.

As used herein, the term "protonation", refers to the addition of a proton to an atom, molecule, or ion, forming a conjugate acid.

As used herein, the term "Coefficient of Thermal Expansion (CTE)", refers to changes in dimensions of an object in function of the temperature. In the present invention, the unit of CTE is expressed in ppm/°C.

As used herein, the term "pendant group", refers to a functional group, when added in the die attach sinter composition, that prefers to be surrounded by the metal (nano) particles over the other components present in the die attach sinter composition.

As used herein, the term "adhesion promoter", refers to a compound having a structure comprising a functional group that preferably is anchored to a carbonaceous platelet, typically via one or more surface anchoring moieties as known in the field (including but not limited to silicanes) and a pendant group having a high affinity to the metal (nano) particles.

The invention is described more fully hereinafter with reference to the accompanying drawings, in which embodiments of the invention are shown. In the drawings, the absolute and relative sizes of systems, components, layers, and regions may be exaggerated for clarity. Embodiments may be described with reference to schematic and/or cross-section illustrations of possibly idealized embodiments and intermediate structures of the invention. In the description and drawings, like numbers refer to like elements throughout. Relative terms as well as derivatives thereof should be construed to refer to the orientation as then described or as shown in the drawing under discussion. These relative terms are for convenience of description and do not require that the system be constructed or operated in a particular orientation unless stated otherwise.

The rapid expansion of electronics into industries like automotive, building and construction have further increased the attention to optimize the efficiency of electronic components in packaged die products. One aspect to control the efficiency of electronic components is to more efficiently remove to heat generated during the usage of said electronic components. Nowadays, the power of electronic components increase year by year, hence the heat generated, increases accordingly. Heat, is known for having a negative effect on the performance as well as the lifetime of the electronic components present in a packaged die product. To remove the heat generated during usage, a proper bond needs to be established between a die and a substrate such as a leadframe. The bond comprising at least a high thermal as well as a high electrical conductivity. High conductive properties allow quick heat removal as will as an efficient transfer of electrical signals.

As of today, most of the dies are bonded to the leadframe by soldering lead (Pb) based or SAC-based compositions. Use of Pb-based compositions is increasingly restricted, primarily in view of potential health risk and/o negative environmental effects. While SAC-based compositions are essentially Pb-free, they are generally known for having lower conductive properties and for having a lower melting. Hence, SAC-based compositions cannot be used at package level soldering. Therefore, not ideal for the higher power demand in packaged die products and the heat associated with it.

To bypass the disadvantages of aforementioned Pb-based as well as SAC-based solders new materials, based on silver (Ag) and copper (Cu), have been developed and commercialized. These materials are known as die attach sinter compositions. Ag and Cu are selected for their high conductive properties and for the lowering the energy affiliated with sintering Ag or Cu. While Ag and/or Cu-based die attach sinter compositions positively influence conductive properties, they are also known for their brittle character and for a higher difference in Coefficient of Thermal Expansion (CTE) compared to the bond pads used in the packaged die product. A higher difference in CTE is associated with an increased stress at the bond pads. Therefore, the increased difference in CTE results in a higher probability of crack formation/propagation at the bond interfaces between the die attach sinter material and the die/leadframe.

According to the invention amines may be used to modify graphene platelets to increase the affinity to metal (nano) particles. CN111423834B describes a graphene/nano-silver composite conductive epoxy based adhesive. The method of preparing amine modified graphene with to covalently link the graphene to the epoxy.

In the present context of die sinter compositions amine as functional groups can potentially may be disadvantageously subject to protonation, e.g. due to acid present under sintering under reducing conductions. A protonated amine (e.g. NH₃⁺) will not bind as strongly with the surface of metal (nano) particles present in the die attach sinter composition. Hence, the probability of forming cracks at an interface of the modified graphene platelet and metal (nano) particles may increase.

It is an aspect of the present invention to provide a die attach sintering composition 1 that mitigates or optionally even eliminates the probability of crack formation and/or propagation during the production of a packaged die product or during the lifetime of the packaged die product. This while maintaining the desired material properties such as thermal conductivity, electrical conductivity, CTE or stiffness associated with electronics.

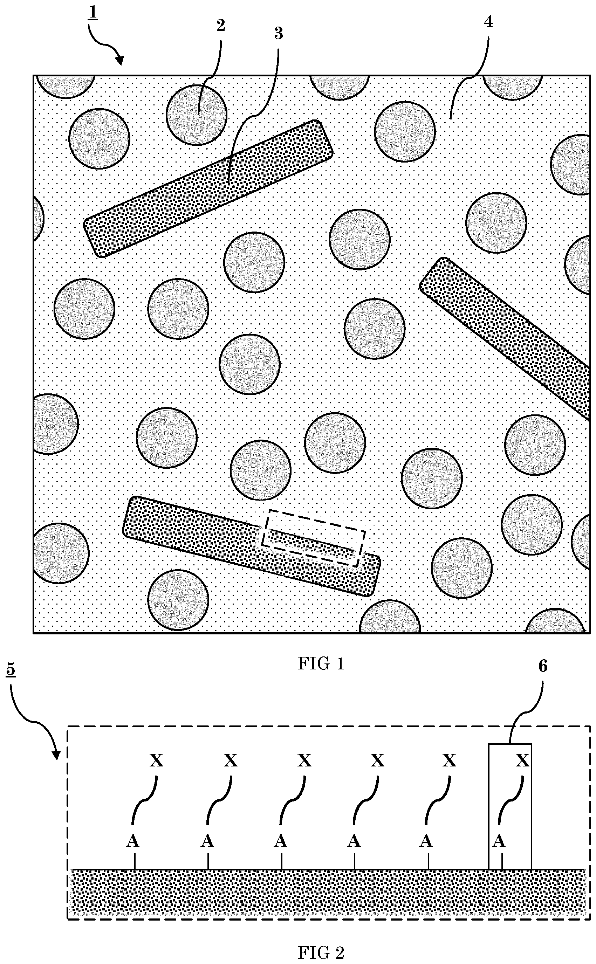

FIG 1 illustrates an embodiment of the present invention. Here, a die attach sinter composition 1 is illustrated, the die attach sinter composition 1 comprising:
- metal (nano) particles 2;
- carbonaceous platelets 3, dispersed with the metal (nano) particles 2 in a common carrier 4.

The carbonaceous platelets 3 being modified with an adhesion promoter 6. Said adhesion promotor 6 is anchored A to said platelets 3 and comprises a pendant group X having an affinity to binding to a surface of the metal (nano) particles 2. The pendant group X of said adhesion promotor 6 remains stable under reducing conditions during sintering of said metal (nano) particles 2.

The metal (nano) particles 2, preferably are selected from Ag, Cu or a combination thereof. The particles generally have a maximum cross-section dimension <1 µm.

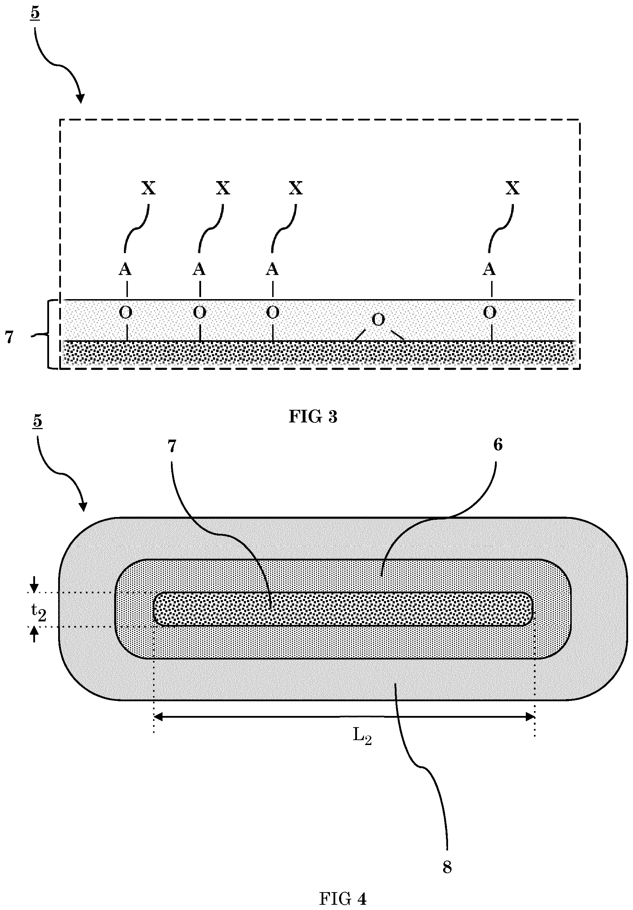

The carbonaceous platelet 3, can in principle be any carbonaceous platelet as knows. Preferably, the carbonaceous platelet 3 is a graphene platelet or reduced graphene oxide platelet, more preferably a functionalized graphene platelet 5. A functionalized carbonaceous or a functionalized reduced graphene oxide platelet 7 are shown in respective FIG 2 and FIG 3.

The common carrier 4, can be any common carrier 4 described to date for that purpose, and which is preferably compatible with the die attach sinter composition 1. Examples of constituents comprised in the common carrier 4 include one or more of solvents (like for example ethyl acetate), thickeners, epoxy moieties.

The adhesion promoter 6, as shown in FIG 2 and FIG 3, is provided to increase the affinity of the carbonaceous platelets 3 towards the metal (nano) particles 2. Said adhesion promoter 6 comprising an anchor A, a backbone and a pendant group X. Said anchor A comprising a functional group having a high affinity with the carbonaceous platelet with reactive hydroxide groups 3. Hence, the anchor prefers the presence of a carbonaceous platelet 3. Examples of an anchor include silanes, phosphides, diazonium salts. The aforementioned anchors can for example be used for Thiolene click reactions. The pendant group X comprises a functional group also known as functionality. Examples of a functional group includes a thiol, an amine, a carboxylic acid based, a phosphate, any combination thereof, or derivates thereof. Preferably the functionality is a mercapto comprising moiety such as a thiol or a thioether. Thiol and its derivatives have the advantage to be stable under reducing conditions during sintering of the metal (nano) particles 2 as well as to epoxy moieties. Therefore, thiols and its derivatives mitigate or eliminate the likelihood of protonating the pendant group X under reducing conditions during sintering of the metal (nano) particles 2

The reducing environment, preferably being achieved through the activation of an acid precursor. The activation preferably done by temperature. Such that the acid precursor decomposes at said temperature to an acid. A reducing environment is generally provided to remove metal oxides present at an outer surface of the metal (nano) particles 2. Metal oxides, especially copper oxides, have the drawback to delay or terminate sintering of the metal (nano) particles 2.

In another embodiment of the present invention, the carbonaceous platelet 3, present in the die attach sinter composition 1 according to the present invention, may optionally comprise an exterior metallized layer 8 covering the modified carbonaceous platelet 5. Preferably, the exterior metallized layer 8 fully encapsulates the modified carbonaceous platelet 5 as is depicted in FIG 4.

The exterior metallized layer 8 preferably is a metal compound selected from Ag, Cu, Au, or a combination thereof. The exterior metallized layer 8 can be applied via any known process to date for that purpose. The exterior metallized layer 8 can, e.g. be suitably provided by known processes including electroless plating.

The metal compound used for the metal (nano) particles 2 and used for the metal in the exterior metallized layer 8 are preferably formed from the same metal composition. Preferably, the metal is selected from Ag, Cu. Selecting the same metal compound for the metal (nano) particles 2 and the exterior metallized layer 8 has the advantage that alloy formation can be avoided during sintering. Alloys are known for lowering the conductive properties of the die attach sinter material. Hence, using the same metal compound can result in higher conductive properties compared to a die attach sinter composition 1 according to the present invention with different metal compounds in the metal (nano) particles 2 and the exterior metallized layer 8.

Furthermore, providing the exterior metallized layer 8 has the advantage to stabilize pendant groups X like amines or groups otherwise non-stable under reducing conditions during sintering of the metal (nano) particles 2. Encapsulating said non-stable pendant group X by said exterior metallized layer 8 shields said pendant group X from a reducing environment. Consequently, exterior metallized non-stable pendant groups X are unable to protonate under the aforementioned conditions. Therefore, mitigating the likelihood of crack formation/propagation normally affiliated with amine functionalized graphene platelets without the presence of the exterior metallized layer.

In another or further embodiment of the present invention, the die attach sinter composition 1 according to the present invention optionally may comprise carbonaceous platelets 3 with an aspect ratio ≥ 3*10². The aspect ratio being defined as a maximum cross-section dimension L₂ over a thickness t₂ of said carbonaceous platelets 3 (see FIG 4). A higher aspect ratio increases accommodation of stress along the primarily fault direction, i.e. a direction along a plane between the die and lead frame.

A maximum cross-section dimension L₂ is generally defined by practical considerations, e.g. availability of platelets, an intended thickness of the sintered die attach layer, and or a nozzle diameter of the device the sinter composition is to be applied from application. In practice an upper bound can be about 100 µm. Preferably, the cross-section dimension L₂ is in a range of 5 to 30 µm, more preferably in a range of 18 to 30 µm. The thickness t₂ is generally in a range of 1 to 5 nm. It will be appreciated that, although less preferred, the composition can comprise thicker platelets or clusters of stacked platelets.

In another or yet further embodiment of the present invention, the Coefficient of Thermal Expansion (CTE) of a sintered die attach sinter composition 1, when sintered, according to the present invention is in between the CTE of a die 10 metal and the (nano) particles 2. Preferably the CTE (when sintered) is in a range of 5 to 17 ppm/°C. The CTE can be regulated by modifying the content of carbonaceous platelets and metal particles present in the die attach material composition 1. For reference, graphene has a CTE close to 0, whereas while metal (nano) particles generally have a CTE around 17 ppm/°C.

In a further embodiment of the present invention, the CTE of the carbonaceous may be anisotropic.

The weight content of the carbonaceous platelets 3 present in the die attach sinter composition 1 according to the present invention, is typically in a range of 0.5 to 4 wt%, preferably in a range of 1 to 3 wt%. Amounts smaller than 0.5 wt% are technically possible but may provide limited benefit as to increases stability.

The present invention further provides a method of packaging a die 9, the method comprising:
- disposing 101 a quantity of the die attach sinter composition 1 according to the present invention between bond pads of the die 10 and corresponding leads 11 of a leadframe 12
- heating 103 under reducing conditions and at a temperature in a range of 150°C to 300°C, thereby sintering the die attach sinter composition 1 according to the present invention such that a die attach sinter material 13 is formed.

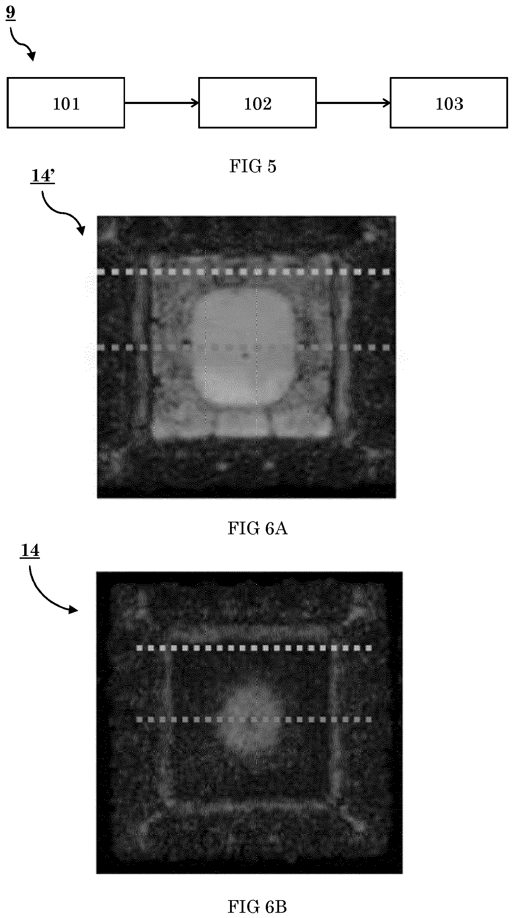

As indicted in FIG 5, the method can comprise applying 102 a contact pressure between the die 10 and the frame 12 heating thereby causing spreading of the disposed quantity of die attach sinter composition 1. The pressure can be applied prior and/or during the sintering. The contact pressure is preferably ≥ 9 MPa.

The present invention further provides a packaged die product. FIG 6A representing a packaged die product comprising a reference product 14' (Heraeus D295A) and FIG 6B representing a packaged die product comprising a sintered die attach sinter composition 1 according to the present invention. Both images are obtained after reparative thermal cycling (2000 TMCL cycles).

The packaged die product 14 (and the comparative example 14') comprises a die 10 (10'), a leadframe 12 (12'), and a sintered die attach material 13 (13') forming an interface 15 (15') between the respective leads 11 (11') of the die and the leads of the leadframe. Preferably the die attach sinter material is a sintered die attach sinter composition 1 according to the present invention. The die attach sinter material 13 comprising a network comprised of sintered metal (nano) particles and carbonaceous platelets 3, dispersed with the network of sintered particles. The carbonaceous platelets 3 being modified with an adhesion promoter 6 that is anchored to said platelets 3 and that comprises a pendant group X bound to a surface of the network comprised of sintered metal particles of the metal (nano) particles 2.

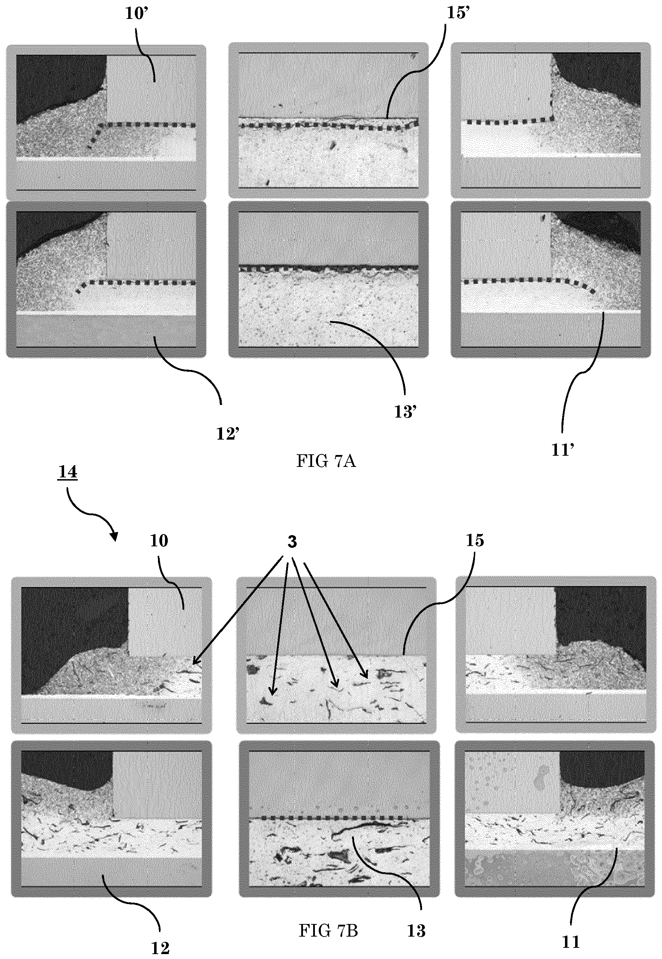

As best seen in FIG 7B carbonaceous platelets 3 have a preferential orientation in a direction parallel to the bond pads.

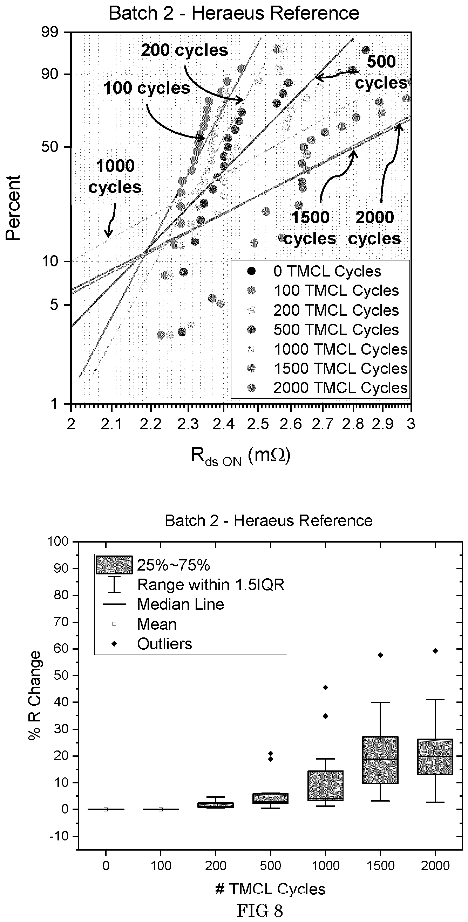

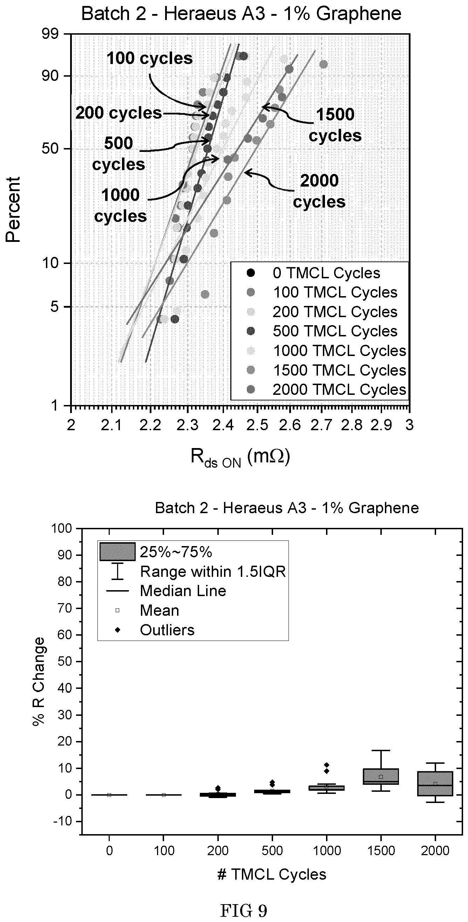

FIG 7A and 7B display 2 cross sections of respectively a reference product (FIG 7A) and a product according to the present invention (FIG 7B). The upper row of micrographs in FIGS 7A and 7B are associated with a cross section away from the bond pad of the die (see upper dashed line in figs 6A/B), while the lower row of micrographs in FIGS 7A and 7B are associated with a cross section through the die 10 and the die attach sinter material 13 (see lower dashed line in FIGs 6A/B). Comparing the reference die attach sinter material with a die attach sinter material 13 according to the present invention reveals that considerable less visible crack formation in the die attach sinter material 13 according the present invention. While the reference die attach sinter material, undeniably, shows cracks within the die attach sinter material (uppermost pictures) and cracks at the bond pads between the die and the reference die attach sinter material. These results are also accompanied by the Weibull plots depicted in FIG 8 (reference die attach sinter material) and FIG 9 (die attach sinter material according to the present invention (Heraeus with 1wt% functionalized graphene platelets added).

For the purpose of clarity and a concise description, features are described herein as part of the same or separate embodiments, however, it will be appreciated that the scope of the invention may include embodiments having combinations of all or some of the features described.

In interpreting the appended claims, it should be understood that the word "comprising" does not exclude the presence of other elements or acts than those listed in a given claim; the word "a" or "an" preceding an element does not exclude the presence of a plurality of such elements; any reference signs in the claims do not limit their scope; several "means" may be represented by the same or different item(s) or implemented structure or function; any of the disclosed devices or portions thereof may be combined together or separated into further portions unless specifically stated otherwise. Where one claim refers to another claim, this may indicate synergetic advantage achieved by the combination of their respective features. But the mere fact that certain measures are recited in mutually different claims does not indicate that a combination of these measures cannot also be used to advantage. The present embodiments may thus include all working combinations of the claims wherein each claim can in principle refer to any preceding claim unless clearly excluded by context.

## Claims

1. A die attach sinter composition (1) comprising:
- metal (nano) particles (2), and
- carbonaceous platelets (3), dispersed with the metal (nano) particles (2) in a common carrier (4), wherein the carbonaceous platelets (3) are modified with an adhesion promoter (6), wherein said adhesion promotor (6) is anchored (A) to said platelets (3) and comprises a pendant group (X) having an affinity to binding to a surface of the metal (nano) particles (2) and wherein the pendant group (X) of said adhesion promotor (6) remains stable under reducing conditions during sintering of said metal (nano) particles (2).

2. The die attach sinter composition (1) according to claim 1, wherein the metal (nano) particles (2) are comprised of a metal selected from Ag or Cu.

3. The die attach sinter composition (1) according to claims 1 or 2, wherein the carbonaceous platelets (3) comprise an exterior metallized layer (8) covering the modified platelets (5).

4. The die attach sinter composition (1) according to claim 3, wherein a metal compound comprised in the metal (nano) particles (2) and in the exterior metallized layer (8) are both comprised of either Ag or Cu.

5. The die attach sinter composition (1) according to any of claims 1 - 4, wherein the pendant group (X) comprises a functionality selected from one or more of: a thiol, an amine, a carboxylic acid based, a phosphate, or derivatives thereof, whereby if the pendant group (X) is amine based the carbonaceous platelets (5) comprise the exterior metallized layer (8) as specified in claim 3.

6. The die attach sinter composition (1) according to claim any of the preceding claims, wherein the functionality of the pendant group (X) is a thiol or a derivative thereof.

7. The die attach sinter composition (1) according to any of the preceding claims, wherein said carbonaceous platelets (3) are graphene platelets that have an aspect ratio ≥ 3^{∗}10².

8. The die attach sinter composition (1) according to any of the preceding claims, wherein a maximum cross-section dimension (L₂) of the platelets (3) is in a range of 5 to 30 µm and a thickness (t₂) is in a range of 1 to 5 nm.

9. The die attach sinter composition (1) according to any of the preceding claims, wherein a weight content of the carbonaceous platelets (3) is in a range of 0.5-4 wt%, preferably in a range of 1-3 wt%, as based on an overall mass of the metal (nano) particles (2) comprised in the die attach sinter composition (1).

10. A method of packaging a die (9), said method comprising:
- disposing (101) a quantity of the die attach sinter composition (1) according to any of the preceding claims between bond pads of the die (10) and corresponding leads (11) of a leadframe (12);
- heating (103) under reducing conditions and at a temperature in range of 150°C to 300°C, thereby sintering the die attach sinter composition (1) such that a die attach sinter material (14) is formed.

11. A method of packaging a die (9) according to claim 10, said method further comprising applying (102) a contact pressure between the die (10) and the frame (12).

12. A packaged die product (14), preferably obtained by the method according to any of the claims 10 or 11, said product comprising a die (10), a leadframe (12), and a sintered die attach material (13) forming an interface (15) between respective bond pads of the die (10) and leads (11) of the leadframe (12), wherein the sintered die attach material (13) comprises a network comprised of sintered metal particles and carbonaceous platelets (3) dispersed with the network particles, wherein said carbonaceous platelets (3) are modified with an adhesion promoter (6) that is anchored (A) to said platelets (3) and that comprises a pendant group (X) bound to a surface of the network comprised of sintered metal particles.

13. The die package product (14) according to claim 12, wherein a thickness of the die attach sinter material (13) is in a range of 20 - 150 µm.

14. The die package product (14) according to any of claims 12-13, wherein the thickness of the die attach sinter material (13) is in a range of 30 to 50 µm and wherein a Coefficient of Thermal Expansion (CTE) of the die attach sinter material is in a range of 5 to 17 ppm/°C.

15. The die package product (14) according to any of claims 12-14, wherein the carbonaceous platelets (3) are oriented predominantly parallel (± 20 degrees) to the bond pads.
